# FASCICULE DE BREVET EUROPEEN

(11) **EP 1 678 755 B1**
(45) Date de publication et mention de la délivrance du brevet: **17.10.2012**
(21) Numéro de dépôt: 04805336.7
(22) Date de dépôt: 28.10.2004
(51) Int. Cl.: H01L 21/762

(54) **PROCEDE DE TRANSFERT CATASTROPHIQUE D UNE COUCHE FINE APRES CO-IMPLANTATION**
VERFAHREN ZUM KATASTROPHISCHEN TRANSFER EINER DÜNNEN SCHICHT NACH COIMPLANTATION
METHOD FOR THE CATASTROPHIC TRANSFER OF A THIN LAYER AFTER CO-IMPLANTATION

(30) Priorité: 28.10.2003 FR 0312621
(43) Date de publication de la demande: 12.07.2006
(73) Titulaire: Soitec, 38190 Bernin (FR); Commissariat à l'Énergie Atomique et aux Énergies Alternatives, 75015 Paris (FR)
(72) Inventeur: NGUYEN, Nguyet-Phuong, F-38100 Grenoble (FR); CAYREFOURCQ, Ian, F-38330 Saint Nazaire les Eymes (FR); LAGAHE-BLANCHARD, Christelle, F-38134 Saint Joseph de Rivière (FR)
(74) Mandataire: Collin, Jérôme
(86) Numéro de dépôt international: PCT/FR2004/002781
(87) Numéro de publication internationale: WO 2005/043616

(56) Documents cités:
- WO-A-00/63965
- WO-A1-02/05344
- US-A1- 2002 025 604
- US-A1- 2003 077 885
- US-B1- 6 593 212
- AGARWAL A ET AL: "EFFICIENT PRODUCTION OF SILICON-ON-INSULATOR FILMS BY CO- IMPLANTATION OF HE+ WITH H+" APPLIED PHYSICS LETTERS, AMERICAN INSTITUTE OF PHYSICS. NEW YORK, US, vol. 72, no. 9, 2 mars 1998 (1998-03-02), pages 1086-1088, XP000742819 ISSN: 0003-6951 cité dans la demande

## Description

### Domaine de l'invention

L'invention concerne un procédé de transfert d'une couche ultra-fine (on parle aussi de couche mince ou ultra-mince) à basse température par la méthode de co-implantation. Elle trouve des applications en particulier dans les domaines de la micro-électronique, de la micro-mécanique, de l'optique et de l'électronique intégrée.

### Etat de la technique

Ainsi qu'on le sait, le détachement d'une couche mince peut être obtenu par implantation d'espèces chimiques dans un substrat source, par exemple en silicium, pour induire la formation d'une zone de défauts à une certaine profondeur. Ces défauts peuvent être des micro-bulles et/ou des platelets et/ou des micro-cavités et/ou des boucles de dislocations et/ou d'autres défauts cristallins, perturbant localement la qualité cristalline du matériau ; leur nature, leur densité et leur taille dépendent beaucoup de l'espèce implantée (de l'hydrogène, typiquement) ainsi que de la nature du substrat source. Un traitement thermique peut ensuite être appliqué pour permettre le développement des défauts spécifiques présents dans la zone fragilisée, ce qui permet d'obtenir le détachement ultérieur de la couche mince du substrat source, en principe par mise sous pression des défauts. Ceci a notamment été décrit dans le document US-5 374 564 et ses développements, dont le document US-6 020 252, et le document WO 00/63965.

Le détachement peut se faire en appliquant, généralement suite au traitement thermique, une force extérieure qui provoque la fracture dans la zone fragilisée jusqu'au détachement de la couche mince.

Lorsque le détachement est réalisé à haute température (typiquement vers 500°C environ), parmi les problèmes technologiques rencontrés, il faut citer la rugosité de la surface ainsi que la dégradation de la couche transférée au cours du détachement thermique. Cela rend plus difficiles les é tapes suivantes de traitement (par exemple : il faut polir p lus la c ouche transférée, des défauts cristallins risquent d'être créés pendant les traitements suivants, ...). De plus, dans les hétéro-structures (comportant une superposition de substrats en matériaux différents), un autre problème technologique rencontré est la présence d'un champ de contraintes très fort dans les diverses couches en contact, au cours du traitement thermique, en raison de la différence des coefficients de dilatation thermique des divers matériaux mis en contact. Cela peut induire la dégradation des hétéro-structures si le détachement thermique s'opère à une température plus haute qu'une température critique. Cette dégradation peut être, typiquement, la casse d'un ou des deux substrats mis en contact et/ou le décollement des substrats au niveau de l'interface de collage.

C'est pourquoi il peut être souhaité d'obtenir le détachement à plus basse température.

Une façon d'obtenir le détachement à basse température est de "jouer" avec les conditions d'implantation. Par exemple, un surdosage de l'espèce implantée permet d'augmenter la fragilisation de la zone implantée dans laquelle a lieu le détachement à basse température.

C'est ainsi que Henttinen et al. (2000) [1] ont montré que, si le substrat source est une plaque de silicium, une dose d'ions d'hydrogène implantés de 1.10¹⁷ H⁺/cm² (soit 5.10¹⁶ H₂/cm²) permet le détachement par une force mécanique, a près réalisation des é tapes suivantes : traitement, d e même que le substrat cible, par une activation chimique de plasma ; nettoyage de type RCA1, collage à température ambiante du substrat source sur le substrat cible, et recuit à 200°C pendant 2h. La force mécanique utilisée provenait d'une lame insérée à l'interface collé pour initier le détachement.

Cette approche, bien que diminuant la rugosité de la surface transférée (de l'ordre de la moitié par rapport aux solutions classiques de détachement, purement thermiques et sans activation plasma), implique une étape d'activation chimique de plasma suivie d'un nettoyage RCA1, ce qui peut représenter un inconvénient important d'un point de vue industriel (coût élevé).

De plus, il est important de noter que, du fait de la forte dose d'hydrogène implantée, le traitement thermique après collage ne doit pas dépasser 300°C, température à laquelle un détachement thermique pourrait avoir lieu, auquel cas on n'obtiendrait plus l'avantage précité de la diminution de la rugosité de la surface transférée : une étape d'activation chimique de plasma, suivie d'un nettoyage RCA1 est d onc indispensable pour renforcer le collage avant sa consolidation thermique suivant la technique décrite par HENTTINNEN.

Il est important de noter que, en fait, ce n'est pas uniquement la température de traitement qui conditionne les conditions ultérieures de détachement de la couche mince, mais aussi la durée de ce traitement, ce qui s'est traduit par la notion de budget thermique (voir FR-2 767 416 - CEA) ; quant à l'apport d'énergie mécanique, il est par exemple appliqué par un outil de type "guillotine" (voir WO 02/083387 - SOITEC).

Ainsi, on a constaté que, si le budget thermique est trop faible, le transfert de la couche mince est de mauvaise qualité, tandis que s'il est trop élevé, il peut y avoir fracture de l'un des substrats dans le cas d'une hétérostructure. On comprend donc qu'il existe en principe une fenêtre étroite pour les paramètres opératoires, (bien entendu liée aux conditions, notamment les doses implantées, la nature des matériaux, les températures de recuit, ...), or cette étroitesse constitue une contrainte lourde pour une exploitation industrielle.

Par ailleurs, le détachement mécanique consiste souvent à introduire une ou plusieurs lames depuis les bords de la structure, comme pour la "découper" le long de la zone fragilisée ; on parle parfois de détachement assisté, puisque le rôle d e l'outil (tel q u'une lame) est de propager l'onde d e fracture d'un bord à l'autre de la structure.

Ce type de fracture amène les défauts suivants, au niveau de la future surface dégagée par le détachement de la couche mince :
- défaut de couronne (zone non transférée, à la périphérie du produit final), par exemple lié à une énergie de collage local trop faible par rapport au reste de l'interface, et à l'introduction des outils pour entamer le transfert,
- non uniformité (rugosité à basse fréquence) de l'épaisseur de la couche mince transférée, notamment en raison de l'onde de fracture assistée mécaniquement, donc irrégulière, par à coups, ce qui nécessite ensuite des traitements, tels qu'un polissage, que l'on cherche pourtant à éviter de manière générale,
- difficile déploiement industriel, compte tenu de l'utilisation d'un outil qui accompagne la propagation de la fracture, ce qui implique un traitement individuel de chaque structure (ou plaque).

La plupart de ces inconvénients se retrouve dans le cas du détachement d'une c ouche mince d ans u n substrat homogène (avec un seul matériau constitutif (SOI, par exemple).

Le détachement de la couche mince est bien sûr également conditionné par le choix des espèces chimiques implantées.

Il a été indiqué ci-dessus qu'on implante généralement de l'hydrogène, mais d'autres options ont été proposées, notamment en implantant de l'hélium.

Il peut même y avoir combinaison de deux espèces chimiques différentes.

C'est ainsi que Agarwal et al. (1998) [2] ont constaté que le fait d'implanter à la fois de l'hydrogène et de l'hélium permettait de réduire la dose totale d'ions implantés, en raison semble t'il de rôles différents joués par l'hydrogène et par l'hélium : l'hydrogène interagit avec les liaisons Si-Si brisées par l'implantation, pour créer des liaisons Si-H, ce qui aboutit à une grande densité de défauts de type platelets d'une taille de l'ordre de 3-10 nm (appelés H-défauts, de type platelet), tandis que l'hélium, qui n'agit pas chimiquement, conduit à l'apparition d'une moindre densité de défauts plus grands (taille supérieure à 300 nm environ). Les traitements thermiques envisagés dans cet article sont de 450°C pendant 20 mn ou de 750°C pendant 20s, ce qui implique nécessairement les inconvénients précités à propos du détachement à haute température.

Cette combinaison hydrogène-hélium a aussi été étudiée, de manière plus théorique, par Cerofolini et al. (2000) [3], qui ont noté que la mise sous pression des défauts était plus forte avec l'implantation de l'hélium qu'avec celle de l'hydrogène, et que le traitement thermique pouvait avoir des effets différents selon la température choisie : un recuit entre 150°C-250°C provoque une diminution du nombre de liaisons Si-H, un recuit dans la gamme 300°C-450°C provoque au contraire une augmentation de ce nombre, tandis qu'un recuit au-delà de 550°C tend plutôt à faire diminuer à nouveau ce nombre. Mais cet article n'en déduit pas de conclusions pratiquesquant à la manière d'obtenir des couches minces de bonne qualité (notamment du point état de surface) pour un coût modéré.

L'invention a pour objet de pallier les inconvénients précités.

Plus précisément, l'invention a pour objet un procédé de transfert d'une couche mince conduisant à une faible rugosité de la surface de la couche transférée, et n'impliquant pas de fortes contraintes mécaniques en cas de matériaux présentant de grandes différences d e coefficients de dilatation. E n d'autres termes, l'invention vise à obtenir, pour un coût modéré, des couches minces de grande qualité, en évitant donc, à la fois les inconvénients d'un traitement thermique à haute température et ceux liés à l'usage d'un outil pour un détachement assisté, et ceux liés à un traitement additionnel pour diminuer la rugosité après détachement.

### Présentation de l'invention

L'invention propose à cet effet un procédé de transfert catastrophique d'une couche fine selon lequel :
- on prépare un substrat source,
- on implante dans ce substrat-source une première espèce d'ions ou de gaz dans une première dose à une profondeur donnée par rapport à une face de ce substrat-source, et une seconde espèce d'ions ou de gaz dans une seconde dose, cette première espèce étant apte à générer des défauts et la seconde espèce étant apte à occuper ces défauts,
- on applique un raidisseur en contact intime avec le substrat-source,
- on applique un traitement thermique à ce substrat-source, à une température donnée pendant un temps donné, en sorte de créer, sensiblement à la profondeur donnée, une zone enterrée fragilisée, sans initier le détachement thermique de la couche fine,
- on applique un apport localisé d'énergie à ce substrat-source pour initier une onde de fracture qui se propage de manière entretenue de sorte de provoquer le détachement catastrophique d'une couche fine délimitée entre la face et la couche enterrée fragilisée, vis-à-vis du reste du substrat-source, cette couche mince ayant à l'opposé de la dite face, une face dont la rugosité est inférieure à un seuil donné.

On peut définir ici un détachement catastrophique comme étant un détachement complet et quasi-instantané, analogue à celui obtenu par un simple traitement thermique à haute température, mais provoqué par un éventuel outil sans que celui-ci ait à suivre une quelconque onde de fracture (s'il y a un outil, il vient donc au plus en contact avec le substrat et la couche, sans longer l'interface de détachement) ; c'est donc, en d'autres termes, le résultat d'une propagation auto-entretenue d'une onde de fracture, c'est-à-dire le contraire d'un détachement assisté.

Par propagation auto entretenue de l'onde de fracture, il est entendu qu'il n'est pas nécessaire d'assister la propagation de l'onde en faisant avancer un outil ou en répétant l'impulsion d'énergie d'initiation. Et une caractéristique importante de l'invention est que l'onde de fracture est propagée sur toute la surface de la plaque en moins de 1 seconde, voire de l'ordre de la milliseconde (vitesses supérieurs à 100m/sec) pour des diamètres jusqu'à 300mm.

Une origine possible de la fracture auto-entretenue vient de la nature des défauts enterrés. Des études menées (dans le Germanium, mais applicable au Silicium) ont montré que dans les conditions de « C-splitting» la densité de défauts (micro fissures, cavités, platelets, micro et macro bulles, ...) est comprise entre 0,03 et 0, 035 par micron carré, leurs tailles sont de l'ordre de 7 à 8 microns carrés, et d'une manière qui semble plus caractérisante, la surface ouverte par ces défauts par rapport à la surface totale de la plaque est comprise entre 25 et 32 %. Ces valeurs sont similaires à celles obtenues lorsque la fracture est obtenue thermiquement, mais diffèrent de celles obtenue après un traitement de fragilisation qui nécessite une fracture mécanique assistée. Bien entendu d'autres effets ou causes ne sont pas exclus par cette interprétation; en particulier la nature chimique des liaisons dans le substrat peut également favoriser l'apparition du phénomène d'onde de fracture auto-entretenue.

En d'autres termes, l'invention semble, selon un aspect, consister à favoriser les conditions de fragilisation proche, dans leur nature, des conditions obtenues lors du la fracture thermique, sans toutefois les conduire jusqu'à ce point. Le complément d'énergie est alors fourni par apport localisé d'énergie.

Plus précisément, l'invention est fondée sur l'implantation de deux espèces différentes. L'une des espèces implantées localise, en fonction de son énergie dimplantation, la zone où se produira ultérieurement le détachement par la formation de défauts spécifiques; l'autre correspond à un type d'atomes piégés dans cette zone qui favorisera l'extension des défauts spécifiques désignés précédemment, apparemment: en augmentant la fragilisation de la zone implantée à relativement basse température en empêchant, dans le cas de l'implantation d'un substrat en silicium par de l'hydrogène, la dissociation Si-H (donc en favorisant les H-défauts du type platelets) et en mettant ces défauts sous pression.

La température de traitement thermique est avantageusement choisie en sorte de favoriser les défauts de type platelets sans pour autant induire de détachement thermique. Cette température sera suffisamment basse pour ne pas générer des contraintes mécaniques importantes dans le substrat dans l'hypothèse où le substrat source et/ou un éventuel substrat cible comporteraient des matériaux présentant des coefficients de dilatation très différents. C'est pourquoi le procédé est un procédé de transfert se produisant à une température relativement basse (pas plus de 400°C pour éviter l'échappement de l'hélium, dans le cas d'une co-implantation Hydrogène-Hélium).

Il mérite d'être souligné que, selon invention, en co-implantant deux espèces gazeuses, telles que l'hydrogène et l'hélium, et en fragilisant thermiquement la structure à basse température (en dessous du seuil précité de 400°C, voire en dessous de 300°C), il a été observé que, de manière tout à fait surprenante, on change la nature du détachement (ou "splitting" en anglais) ; on parvient ainsi à fragiliser très fortement la zone implantée sans générer de détachement purement thermique, et cela quelque soit le temps de recuit (pas de détachement observé après 24h de recuit à la basse température définie ci-dessus) ; par contre, le détachement se déclenche de manière catastrophique, par simple apport d'énergie localisé dans le temps et dans l'espace (tel qu'un choc mécanique au niveau de l'interface fragilisé, par exemple. Il semble ainsi que la notion de budget thermique exposée dans le document FR - 2 767 416 précité ne soit plus appropriée dans le cas d'une co-implantation avec un traitement thermique à basse température dans les conditions énoncées précédemment.

Les conséquences en sont significatives :
- la fenêtre opératoire de l'étape de recuit d e pré-fragilisation est agrandie : il n'existe plus (ou celle-ci est fortement repoussée) de borne maximum pour la durée de ce recuit de pré-fragilisation ; cela est tout à fait favorable à l'industrialisation du procédé,
- il n'y a plus de détachement assisté puisque la fracture catastrophique permet de propager l'onde de fracture instantanément et sans à-coups sur toute la section de la plaque ; il n'est pas nécessaire qu'une quelconque lame pénètre entre le substrat et la future couche mince, ce qui améliore nettement la topologie des surfaces ainsi dégagées (avec donc une rugosité plus faible), et évite les défauts de couronne, ce qui rend utilisable la totalité de la couche mince, y compris sa périphérie ; le fait de ne plus a voir à introduire d'outil est aussi favorable à l'industrialisation du procédé.

Les inventeurs n'ont pas encore d'explications claires pour cette nouvelle cinétique.

Dans la mesure où, au plus tard au moment du traitement thermique, on met le substrat source en contact intime par ladite face à un raidisseur ou substrat cible, le traitement thermique contribue à améliorer l'énergie de collage entre ces substrats.

L'apport localisé d'énergie est de préférence appliqué sous la forme d'un choc ou d'une impulsion. Il peut être appliqué avantageusement par un outil animé d'un mouvement bref et de faible amplitude.

Il est avantageusement appliqué à proximité immédiate de la couche enterrée, limité à une partie seulement de celle- ci, de préférence à une portion périphérique de celle-ci.

Cet apport peut notamment être constitué d'un apport thermique localisé (par exemple appliqué par une impulsion laser) ou d'une contrainte extérieure (par exemple à proximité immédiate de la zone fragilisée, en un bord de celle-ci).

En fait, des essais avec une co-implantation d'hydrogène et d'hélium dans le substrat-source dans les conditions de l'invention ont conduit à un détachement catastrophique, c'est-à-dire un détachement complet et quasi-instantané, avec une propagation continue et plane de l'onde de fracture, initié à l'aide d'un très faible apport localisé d'énergie, ce qui a eu notamment pour avantage d'éviter les ondulations en surface, c'est à dire d'éviter les variations importantes de rugosité de surface après fracture, par comparaison avec un détachement progressif. De ce fait, ce détachement catastrophique implique ensuite un moindre polissage

Il mérite d'être souligné qu'il pouvait paraître a priori difficile de définir un procédé garantissant u ne faible rugosité suite à un détachement à basse température sans activation plasma, dans la mesure où une basse température semblait ne pas permettre un collage assez solide entre substrat-source et substrat-cible du fait d'un interface de collage faible. Bien entendu, le procédé selon l'invention peut sans détriment utiliser une activation plasma d'au moins une des surfaces à mettre en contact, mais contrairement à la technique décrite par HENTTINEN, cette activation n'est pas indispensable.

Préférentiellement, l'implantation de l'espèce créant des défauts qui favorisent le détachement est faite après l'implantation de la seconde espèce ; on obtient avantageusement que cette deuxième espèce est localisée dans la zone des défauts créés par la première espèce.

De manière avantageuse, dans le cas du silicium, cette première espèce est de l'hydrogène (de préférence sous la forme d'ions H⁺), que l'on implante en concentration standard (typiquement d e l'ordre de quelques 10¹⁶ H/cm²), étant rappelé que l'hydrogène montre une efficacité importante pour créer une couche de fragilisation. Au niveau de cette couche, la deuxième espèce (de préférence de l'hélium), jouant le rôle d'atomes piégés pour favoriser la formation des défauts de fragilisation, est implantée avec une dose relativement basse (typiquement de l'ordre de 10¹⁶ He/cm², ou de quelques 10¹⁶ He/cm²)_{.}

Lorsque le substrat source a été collé à un substrat cible, le traitement thermique à basse température (néanmoins suffisante pour obtenir une bonne solidité des interfaces du collage), a pour effet que les atomes de deuxième espèce d'hélium diffusent dans les défauts créés par l'hydrogène. La fragilisation maximale obtenue à cette relativement basse température permet le détachement d'une couche ultra-fine très peu rugueuse (de l'ordre de quelques nm), initié par une force extérieure.

La différence radicale de ce procédé, par rapport à la technique décrite par Henttinen, est qu'il n'est pas nécessaire de réaliser un surdosage de l'hydrogène qui peut fortement endommager la zone implantée. L'effet de la co-implantation permet d'obtenir la fragilisation maximum de cette zone à la température suffisante pour la solidité des interfaces du collage sans l'intervention des procédés supplémentaires (activation chimique de plasma et RCA1). De plus, l'invention conduit à une meilleure rugosité de la couche transférée en comparaison avec celle obtenue par un détachement thermique.

De manière avantageuse, la deuxième espèce (par exemple l'hélium) est implantée au même niveau que la première (hydrogène) mais en variante elle peut être implantée à une profondeur décalée plus importante (par exemple) dans le substrat source pour diminuer la zone dégradée par l'implantation. Ce niveau décalé peut être bien distinct du premier, par exemple beaucoup plus profond dans le substrat source. Dans ce cas, il semble qu'une petite partie de la deuxième espèce implantée soit piégée par les défauts rencontrés sur son chemin d'implantation.

En fait, la co-implantation permet de choisir une température de 200°C à 400°C.

De manière p référée, le substrat source est en un matériau choisi par les semi-conducteurs et les isolants, monocristallins, polycristallins ou amorphes. C'est ainsi qu'il peut être choisi par le les semi-conducteurs IV (un exemple particulièrement intéressant est le silicium mais il peut aussi s'agir de germanium ou d'alliages Si-Ge, notamment).

Au moins dans ce cas, la température de traitement thermique est avantageusement choisie dans la gamme 200°C-400°C, de préférence dans la gamme 300°C-350°C, par exemple pendant une durée de quelques heures (typiquement de l'ordre de 2 à 5 h). Ce substrat source peut aussi être en un matériau semi-conducteur de type III-V, (par exemple As Ga ou InP) ou en un matériau isolant de préférence choisi dans le groupe comportant LiNbO3 et Li TaO3.

Le traitement thermique peut également présenter un profil adapté de manière à réduire le temps de ce traitement, comme il l'est par exemple divulgué dans la demande de brevet européen 02-293049 déposée le 10 décembre 2002.

En fait, la gamme de température dépend principalement de la nature des espèces implantées et de la nature du matériau constitutif du substrat source.

Quant au substrat cible ou raidisseur, il est avantageusement choisi sous la forme d'un matériau a morphe, de préférence sous la forme de silice fondue. Mais il peut aussi s'agir d'un matériau monocristallin ou polycristallin, en silicium ou en saphir, notamment.

### Description générale

Des objets, caractéristiques et avantages de l'invention ressortent de la description qui suit, donnée à titre illustratif non limitatif en regard du dessin annexé, sur lequel :
- la figure 1 est une vue schématique d'un substrat source en cours d'implantation,
- la figure 2 en est une vue ultérieure après mise en contact intime (collage) à un substrat cible, et
- la figure 3 en est une vue en cours de détachement d'une couche fine issue du substrat source.

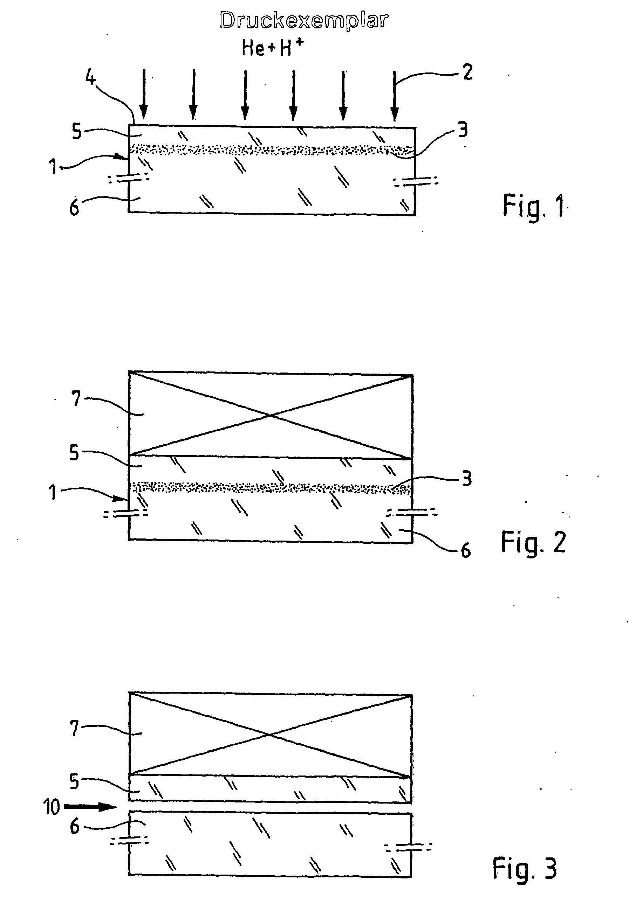

La figure 1 représente ainsi un substrat 1, par exemple en silicium avantageusement oxydé à sa surface 4, en train d'être soumis à un traitement d'implantation, schématisé par les flèches 2, par exemple par bombardement, d'ions ou d'espèces gazeuses.

Cette implantation implique, à une profondeur donnée, l'implantation d'une première espèce qui est apte à générer des défauts, par exemple de l'hydrogène, de préférence sous la forme d'ions H+, et l'implantation d'une seconde espèce apte à occuper ces défauts, par exemple de l'hélium. Dans le cas représenté, les deux espèces sont implantées à la même profondeur, mais en variante, la seconde espèce est implantée à une autre profondeur que la première, par exemple à une plus grande profondeur.

On peut commencer par l'implantation de la première espèce, à savoir l'hydrogène, suite à quoi l'hélium peut occuper des défauts ainsi créés, dès son implantation. Toutefois l'ordre inverse des implantations est préféré, même si les deux implantations ne se font pas à la même profondeur.

Il en résulte une zone enterrée 3 fragilisée par la présence de défauts, principalement générés par la première espèce, et dont la seconde espèce va contribuer au développement.

Cette zone fragilisée 3 délimite, au sein du substrat source, une future couche mince 5 et un reste de substrat source 6, c'est à dire ce qui restera du substrat source après détachement de la couche mince ; ce reste pourra servir de substrat source pour un nouveau cycle de mise en oeuvre du procédé.

La figure 2 représente une étape au cours de laquelle on met le substrat source, contenant la zone enterrée fragilisée 3, par sa face 4, en contact intime avec une face correspondante d'un substrat cible 7, typiquement par collage moléculaire direct, dont la fonction est celle d'un raidisseur.

On applique alors un traitement thermique qui va, d'une part, permettre un développement de la fragilisation de la couche enterrée 3, et d'autre part, lorsqu'une étape de collage a eu lieu, permettre une consolidation des liaisons de collage entre substrat source et substrat cible.

Plus précisément, la température de ce traitement thermique est choisie dans une gamme de températures propres à développer la zone fragilisée, c'est-à-dire les liaisons Si-H dans le cas présent.

Ce traitement est avantageusement conduit à une température choisie dans la gamme 200°C-400°C, de préférence dans la gamme 300°C-350°C, pendant une durée typiquement choisie de quelques heures, par exemple 2 heures. Ainsi, les budgets thermiques (couples température-durée) sont industriellement réalistes.

A la figure 3 est représentée l'étape de détachement de la couche mince 3 vis-à-vis du reste du substrat source, au moyen de l'application d'un apport localisé d'énergie, de préférence bref et d'amplitude limitée, par exemple sous la forme d'un choc ou d'une impulsion.

Il est par exemple constitué d'une contrainte mécanique schématisée par la flèche 10.

Le détachement obtenu est catastrophique en ce sens, notamment qu'il n'y a pas de mouvement d'un outil le long de la couche fragilisée.

Cet apport localisé d'énergie est ici limité à une partie de la couche enterrée, schématisé sous la forme d'un effet de coin correspondant à un choc appliqué par un outil tel qu'une lame sur (ou à proximité d') une portion de cette couche enterrée fragilisée ; mais il peut être de toute autre nature, par exemple un couple parallèle au plan de la zone enterrée fragilisée avantageusement appliqué sous la forme d'une impulsion de faible amplitude angulaire. Grâce au procédé de l'invention, la face de la couche mince qui est libérée par le détachement catastrophique dans la zone enterrée fragilisée (en pratique sensiblement plane) présente une rugosité R a bien plus faible que selon les solutions classiques, sans qu'il ait été nécessaire de prévoir un traitement particulier de la surfaces transférée ni de polissage important (« grossier ») après détachement. Il mérite d'être noté que, puisque le détachement est catastrophique, il n'y a pas de réelle propagation par à-coups d'une onde de fracture susceptible de générer des ondulations en surface, et que, puisqu'il n'y a pas de mouvement d'un quelconque outil le long des surfaces nouvellement créées (ou de mouvement relatif entre les deux parties de part et d'autre de la couche enterrée) il n'y a pas de dégradation des surfaces ainsi libérées, qui ont donc l'état de surface, très lisse, provoqué par le détachement catastrophique.

Le substrat source 1 peut être non seulement en silicium, mais plus généralement en tout matériau connu approprié, par exemple semi-conducteur IV ou III-V, monocristallin ou polycristallin voire amorphe. C'est ainsi que ce substrat source peut être :
- un autre semi-conducteur de la colonne IV du tableau périodique des éléments, par exemple en germanium,
- un semi-conducteur du type III-V tel que AsGa ou InP; notamment,
- un isolant par exemple du type niobate ou tantalate, tels que LiNb03 ou LiTaO3, notamment.

Quant au substrat cible il peut être réalisé dans une grande variété de matériaux, à choisir selon les besoins, monocristallin ou polycristallin (par exemple semi-conducteurs, par exemple parmi les mêmes matériaux que pour le substrat source) voire amorphe (par exemple verres ou polymères) ; c'est ainsi qu'il peut notamment être :
- un matériau cristallin tel que le saphir,
- en silice fondue ou en un autre verre,
- une simple couche de rigidification, par exemple un oxyde de quelques dizaines de nanomètres d'épaisseur, déposée par toute technique connue appropriée (cela ne correspond plus, il est vrai, à un substrat cible massif du type représenté sur les dessins).

Il mérite d'être noté que le substrat cible peut n'être qu'un substrat intermédiaire dont la couche mince est ensuite transférée sur un substrat final.

### Exemples

Selon un premier exemple de réalisation de l'invention, un substrat de Si (-700µm) comportant une couche de SiO₂ thermique en surface (par exemple 145nm) peut être implanté dans un premier temps avec des atomes d'hélium dans les conditions d'implantation 70keV -10¹⁶He/cm², puis implanté avec des atomes d'hydrogène dans les conditions d'implantation 30keV-4,25.10¹⁶H/cm². Ce substrat source peut ensuite être solidarisé sur un substrat cible de Si(-700µm) par collage direct. Un traitement thermique autour de 350°C induit la croissance de cavités de type platelets localisées au niveau du pic de concentration d'hydrogène. Les atomes d'hélium jouent le rôle d'atomes piégés à ce niveau et créent un maximum de défauts de type platelets à la température appliquée. Au bout d'un certain temps (2h par exemple) avec à peine un début d'insertion d'une lame entre les interfaces de collage sous la forme d'un choc, le détachement catastrophique au niveau du maximum de concentration d'hydrogène mène au report de la couche mince de Si sur le substrat cible. La rugosité de la surface transférée mesurée à haute fréquence (en microscopie à force atomique), de l'ordre de 45 à 50 Angströms, et à basse fréquence (par profilométrie), de l'ordre de 10 Angströms, et l'amorphie de cette surface transférée sont bien inférieures à celles qui peuvent être obtenues dans le cas de H-implanté seul (32keV-5,5.10¹⁶H/cm²) suivi d'un traitement thermique à 500° C (rugosité à basse fréquence de l'ordre de 26 Angströms et rugosité à haute fréquence de l'ordre de 75 Angstrôms).

Selon un autre exemple de réalisation de l'invention, un substrat de Si (environ 300µm) comportant une couche de SiO₂ thermique en surface (par exemple 200nm) est implanté dans un premier temps avec des atomes d'hélium dans les conditions d'implantation 70keV-2.10¹⁶He/cm², puis implanté avec des atomes d'hydrogène dans les conditions 30keV-3.10¹⁶H/cm². Ce substrat source est ensuite solidarisé à un substrat cible de silice fondue (environ 1000µm) par collage direct. Un traitement thermique autour de 300° C induit la croissance de cavités de types platelets localisées au niveau du pic de concentration d'hydrogène, les atomes d'hélium implanté piégés par les défauts d'hydrogène favorisant la formation d'un maximum des défauts de type platelets à la température appliquée. Au bout d'un certain temps (3h par exemple), au moyen d'une lame à peine insérée entre les interfaces de collage et animée d'une impulsion de mouvement (donc un choc), le détachement catastrophique au niveau du maximum du profil d'hydrogène mène au report de la couche mince de Si sur le substrat de silice fondue, sans casse ni dégradation de l'un ou l'autre des substrats issus de l'hétérostructure après détachement (le substrat de silice fondue comportant la couche mince de Si d'une part et le substrat de Si initial pelé de la couche mince superficielle d'autre part). La rugosité de la surface transférée, mesurée à basse fréquence par la profilométrie (de l'ordre de 14 Angströms à basse fréquence et de l'ordre de 75 Angströms en haute fréquence) et l'amorphie de cette surface transférée sont bien inférieures à celles qui peuvent être obtenues dans le cas de H-implanté seul (32keV-5,5.10¹⁶H/cm²) suivant le mode de détachement mécanique progressif à haute température (rugosité en haute fréquence de l'ordre de 90 Angströms et de l'ordre de 40 Angströms à basse fréquence).

### Références

[1] K. Henttinen et al., Applied Physics Letters, Volume 16, Number 17, 24 April 2000 ; pp. 2370-2372
[2] A. Argawal et al. Applied Physics Letters, volume 72, Number 9, 2 March 1998 ; pp. 1086-1088
[3] G. F. Cerofolini et al., Materials Science and Engineering B71 - 2000, pp. 196-202

## Revendications

1. Procédé de transfert catastrophique d'une couche fine selon lequel:
- on prépare un substrat source (1),
- on implante dans ce substrat-source une première espèce d'ions ou de gaz dans une première dose à une profondeur donnée par rapport à une face (4) de ce substrat-source, et une seconde espèce d'ions ou de gaz dans une seconde dose, cette première espèce étant apte à générer des défauts est la seconde espèce étant apte à occuper ces défauts,
- on applique un raidisseur (7) en contact intime avec le substrat-source,
- on applique un traitement thermique à ce substrat-source, à une température donnée pendant un temps donné, en sorte de créer, sensiblement à la profondeur donnée, une couche enterrée fragilisée, sans initier le détachement thermique de la couche fine (5) délimitée par la face et la couche enterrée fragilisée,
- on applique un apport localisé d'énergie (10) à une partie de la couche enterrée fragilisée du substrat-source pour initier une onde de fracture qui se propage de manière auto-entretenue de sorte de provoquer le détachement catastrophique c'est-à-dire complet et instantané de la couche fine, (5) vis-à-vis du reste (6) du substrat-source.

2. Procédé selon la revendication 1, **caractérisé en ce que** l'on applique l'apport localisé d'énergie sous la forme d'un apport thermique localisé.

3. Procédé selon la revendication 1, **caractérisé en ce que** l'on applique l'apport localisé d'énergie sous la forme d'un apport d'un mouvement bref et de faible amplitude appliqué au moyen d'un outil.

4. Procédé selon la revendication 1, **caractérisé en ce que** l'on applique l'apport localisé d'énergie sous la forme d'un choc en une zone périphérique de la couche enterrée fragilisée.

5. Procédé selon l'une quelconque des revendications 1 à 4, **caractérisé en ce que** le raidisseur avec lequel le substrat-source est mis en contact intime, au plus tard au moment du traitement thermique, est un substrat cible, le traitement thermique contribuant à améliorer l'énergie de collage entre ces substrats.

6. Procédé selon la revendication 5, **caractérisé en ce que** le substrat cible est en un matériau amorphe.

7. Procédé selon la revendication 5, **caractérisé en ce que** le substrat source est en silicium et le substrat cible est en silice fondue.

8. Procédé selon la revendication 5, **caractérisé en ce que** le substrat cible est un matériau monocristallln ou polycristallin.

9. Procédé selon la revendication 8, **caractérisé en ce que** le substrat cible est en silicium.

10. Procédé selon l'une quelconque des revendications 1 à 9, **caractérisé en ce qu'**on réalise l'implantation de la première espèce après celle de la seconde espèce.

11. Procédé selon l'une quelconque des revendications 1 à 10, **caractérisé en ce qu'**on prépare le substrat source en un matériau choisi parmi les semi-conducteurs et les isolants, monocristallins, polycristallins ou amorphes.

12. Procédé selon la revendication 11, **caractérisé en ce qu'**on prépare le substrat source en un matériau choisi parmi les semi-conducteurs IV.

13. Procédé selon la revendication 12, **caractérisé en ce qu'**on réalise le substrat source en silicium.

14. Procédé selon l'une quelconque des revendications 1 à 13, **caractérisé en ce que** le traitement thermique est réalisé à une température choisie dans la gamme 200°C-400°C.

15. Procédé selon la revendication 14, **caractérisé en ce que** le traitement thermique est réalisé à une température choisie dans la gamme 300°C-350°C,

16. Procédé selon la revendication 14 ou la revendication 15, **caractérisé en ce que** le traitement thermique est conduit pendant environ 2 h à 5h.

17. Procédé selon la revendication 11, **caractérisé en ce qu'**on prépare le substrat source en un matériau semi-conducteur de type III-V.

18. Procédé selon la revendication 11, **caractérisé en ce qu'**on prépare le substrat source en un matériau isolant choisi dans le groupe constitué par LiNbO₃ et LiTaO₃.

19. Procédé selon l'une quelconque des revendications 1 à 18, **caractérisé en ce que** la première espèce est de l'hydrogène.

20. Procédé selon la revendication 19, **caractérisé en ce que** la première espèce est de l'hydrogène de type H⁺.

21. Procédé selon la revendication 20, **caractérisé en ce que** la première espèce est implantée à une dose de l'ordre de quelques 10¹⁶ H/cm².

22. Procédé selon l'une quelconque des revendications 1 à 21, **caractérisé en ce que** la seconde espèce est de l'hélium.

23. Procédé selon la revendication 22, **caractérisé en ce que** la seconde espèce est implantée à une dose de l'ordre de quelques 10¹⁸ He/cm², inférieure à la dose de la première espèce.

## Claims

1. A method of catastrophic transfer of a thin layer wherein:
- a source substrate (1) is prepared,
- into said source substrate is implanted a first species of ions or gas at a first dose at a specified depth with respect to a face (4) of said source substrate, and a second species of ions or gas at a second dose, wherein the first species is capable of generating defects and the second species is capable of occupying said defects,
- a stiffener (7) is applied in close contact with the source substrate,
- heat treatment is applied to said source substrate at a predetermined temperature for a predetermined time, so as to create, substantially at the predetermined depth, a buried weakened zone, without initiating thermal splitting of the thin layer (5) delimited by the face and the buried weakened layer,
- a localized supply of energy (10) is applied to part of the buried weakened layer of the source substrate in order to initiate a fracture wave that propagates in a self-sustaining manner, causing the catastrophic, i.e. complete and instantaneous, detachment of the thin layer (5) from the remainder (6) of the source substrate.

2. The method of claim 1, wherein the localized supply of energy applied is localized thermal energy.

3. The method of claim 1, wherein the localized supply of energy is applied in the form of a brief movement of small amplitude applied by means of a tool.

4. The method of claim 1, wherein the localized supply of energy is applied in the form of a shock in a peripheral zone of the buried weakened layer.

5. The method of any of claims 1 to 4, wherein the stiffener placed in contact with the source substrate, during or before the heat treatment, is a target substrate, the heat treatment helping improve the bonding energy between said source substrate and said target substrate.

6. The method of claim 5, wherein the target substrate is made of an amorphous material.

7. The method of claim 5, wherein the source substrate is made of silicon and the target substrate is made of fused silica.

8. The method of claim 5, wherein the target substrate is made of a monocrystalline or polycrystalline material.

9. The method of claim 8, wherein the target substrate is made of silicon.

10. The method of any of claims 1 to 9, wherein the first species is implanted after the second species.

11. The method of any of claims 1 to 10, wherein the source substrate is made of a material selected from monocrystalline, polycrystalline or amorphous semiconductors and insulators.

12. The method of claim 11, wherein the source substrate is made of material selected from group IV semiconductors.

13. The method of claim 12, wherein the source substrate is made of silicon.

14. The method of any of claims 1 to 13, wherein the heat treatment is carried out at a temperature between 200°C and 400°C.

15. The method of claim 14, wherein the heat treatment is carried out at a temperature between 300°C and 350°C.

16. The method of claim 14 or claim 15, wherein the heat treatment is carried out for roughly 2 to 5 hours.

17. The method of claim 11, wherein the source substrate is made of a group III-V semiconductor material.

18. The method of claim 11, wherein the source substrate is made of an insulating material selected from LiNbO₃ and LiTaO₃.

19. The method of any of claims 1 to 18, wherein the first species is hydrogen.

20. The method of claim 19, wherein the first species is singly-ionized hydrogen H⁺.

21. The method of claim 20, wherein the first species is implanted at a dose on the order of several 10¹⁶ H/cm².

22. The method of any of claims 1 to 21, wherein the second species is helium.

23. The method of claim 22, wherein the second species is implanted at a dose on the order of several 10¹⁶ He/cm², lower than the dose of the first species.

## Patentansprüche

1. Verfahren zur Schockübertragung einer Dünnschicht, gemäß dem:
- ein Quellsubstrat (1) hergestellt wird,
- in dieses Quellsubstrat eine erste Ionensorte oder Gassorte mit einer ersten Dosis in einer vorgegebenen Tiefe relativ zu einer Fläche (4) dieses Quellsubstrats sowie eine zweite Ionensorte oder Gassorte mit einer zweiten Dosis implantiert werden, wobei die erste Sorte dafür geeignet ist, Fehlstellen zu erzeugen, und die zweite Sorte dafür geeignet ist, diese Fehlstellen zu besetzen,
- in engem Kontakt mit dem Quellsubstrat eine Versteifungseinheit (7) angebracht wird,
- auf das Quellsubstrat eine Wärmebehandlung angewendet wird, und dies mit einer vorgegebenen Temperatur und für eine vorgegebene Zeitspanne, derart, dass im Wesentlichen in der vorgegebenen Tiefe eine eingebettete Schwächungsschicht erzeugt wird, und ohne die thermische Ablösung der Dünnschicht (5) auszulösen, die von der Fläche und der eingebetteten Schwächungsschicht begrenzt wird,
- eine konzentrierte Energiezufuhr (10) auf einen Teil der eingebetteten Schwächungsschicht des Quellsubstrats angewendet wird, um eine Bruchwelle auszulösen, die sich auf selbstunterhaltende Weise ausbreitet, derart, dass die schockartige Ablösung, das heißt die vollständige und augenblickliche, der Dünnschicht (5) vom Rest (6) des Quellsubstrats hervorgerufen wird.

2. Verfahren nach Anspruch 1, **dadurch gekennzeichnet, dass** die konzentrierte Energiezufuhr in Form einer konzentrierten Wärmezufuhr angewendet wird.

3. Verfahren nach Anspruch 1, **dadurch gekennzeichnet, dass** die konzentrierte Energiezufuhr in Form einer Anwendung einer Bewegung ausgeführt wird, die kurz und von geringer Auslenkung ist und mittels eines Werkzeugs hervorgerufen wird.

4. Verfahren nach Anspruch 1, **dadurch gekennzeichnet, dass** die konzentrierte Energiezufuhr in Form eines Stoßes in einem Randbereich der eingebetteten Schwächungsschicht angewendet wird.

5. Verfahren nach einem der Ansprüche 1 bis 4, **dadurch gekennzeichnet, dass** die Versteifungseinheit, mit der das Quellsubstrat spätestens zum Zeitpunkt der Wärmebehandlung in engen Kontakt gebracht wird, ein Zielsubstrat ist, wobei die Wärmebehandlung dazu beiträgt, die Haftenergie zwischen diesen Substraten zu verbessern.

6. Verfahren nach Anspruch 5, **dadurch gekennzeichnet, dass** das Zielsubstrat aus einem amorphen Material ist.

7. Verfahren nach Anspruch 5, **dadurch gekennzeichnet, dass** das Quellsubstrat aus Silizium und das Zielsubstrat aus geschmolzenem Silizium sind.

8. Verfahren nach Anspruch 5, **dadurch gekennzeichnet, dass** das Zielsubstrat ein monokristallines oder polykristallines Material ist.

9. Verfahren nach Anspruch 8, **dadurch gekennzeichnet, dass** das Zielsubstrat aus Silizium ist.

10. Verfahren nach einem der Ansprüche 1 bis 9, **dadurch gekennzeichnet, dass** die Implantation der ersten Sorte nach derjenigen der zweiten Sorte ausgeführt wird.

11. Verfahren nach einem der Ansprüche 1 bis 10, **dadurch gekennzeichnet, dass** das Quellsubstrat aus einem Material hergestellt wird, das unter monokristallinen, polykristallinen oder amorphen Halbleitern und Isolierstoffen ausgewählt wird.

12. Verfahren nach Anspruch 11, **dadurch gekennzeichnet, dass** das Quellsubstrat aus einem Material hergestellt wird, das unter den IV-Halbleitern ausgewählt wird.

13. Verfahren nach Anspruch 12, **dadurch gekennzeichnet, dass** das Quellsubstrat aus Silizium hergestellt wird.

14. Verfahren nach einem der Ansprüche 1 bis 13, **dadurch gekennzeichnet, dass** die Wärmebehandlung bei einer Temperatur ausgeführt wird, die aus dem Bereich von 200°C bis 400°C ausgewählt wird.

15. Verfahren nach Anspruch 14, **dadurch gekennzeichnet, dass** die Wärmebehandlung bei einer Temperatur ausgeführt wird, die aus dem Bereich von 300°C bis 350°C ausgewählt wird.

16. Verfahren nach Anspruch 14 oder Anspruch 15, **dadurch gekennzeichnet, dass** die Wärmebehandlung für etwa 2h bis 5h ausgeführt wird.

17. Verfahren nach Anspruch 11, **dadurch gekennzeichnet, dass** das Quellsubstrat aus einem Halbleitermaterial vom Typ III-V hergestellt wird.

18. Verfahren nach Anspruch 11, **dadurch gekennzeichnet, dass** das Quellsubstrat aus einem Isoliermaterial hergestellt wird, das aus der durch LiNbO₃ und LiTaO₃ gebildeten Gruppe ausgewählt wird.

19. Verfahren nach einem der Ansprüche 1 bis 18, **dadurch gekennzeichnet, dass** die erste Sorte Wasserstoff ist.

20. Verfahren nach Anspruch 19, **dadurch gekennzeichnet, dass** die erste Sorte Wasserstoff vom Typ H⁺ ist.

21. Verfahren nach Anspruch 20, **dadurch gekennzeichnet, dass** die erste Sorte mit einer Dosis in der Größenordnung von einigen 10¹⁶ H/cm² implantiert wird.

22. Verfahren nach einem der Ansprüche 1 bis 21, **dadurch gekennzeichnet, dass** die zweite Sorte Helium ist.

23. Verfahren nach Anspruch 22, **dadurch gekennzeichnet, dass** die zweite Sorte mit einer Dosis in der Größenordnung von einigen 10¹⁶ He/cm² und unterhalb der Dosis der ersten Sorte implantiert wird.
